# EUROPEAN PATENT APPLICATION

(11) **EP 3 246 955 A1**
(43) Date of publication of application: **22.11.2017**
(21) Application number: 17169395.5
(22) Date of filing: 04.05.2017
(51) Int. Cl.: H01L 33/06, H01L 33/00, H01L 33/32

(54) **INTERLAYER FOR LIGHT EMITTING DIODE DEVICE**

(30) Priority: 19.05.2016 TW 105115579
(71) Applicant: Lextar Electronics Corp., 30075 Hsinchu (TW)
(72) Inventor: YANG, Chung-Chieh, 429 Shengang Dist., Taichung City (TW); WANG, Te-Chung, 411 Taiping Dist., Taichung City (TW)
(74) Representative: Winter, Brandl, Fürniss, Hübner, Röss, Kaiser, Polte - Partnerschaft mbB

(57) **Abstract**

The present invention is a light emitting diode (LED) device including a substrate, a buffer layer, a first conductivity type semiconductor layer, a light emitting layer, an interlayer, an electron blocking layer, and a second conductivity type semiconductor layer. The thickness of the interlayer is substantially thinner than the thickness of the electron blocking layer. In an embodiment of the present invention, the interlayer is doped with a p-type dopant, and the electron blocking layer is doped with a p-type dopant, and the concentration of the p-type dopant of the interlayer is lower than the concentration of the p-type dopant of the electron blocking layer.

## Description

### BACKGROUND

### Technical Field

The present disclosure relates to a light emitting diode (LED) device. More particularly, the present disclosure is related to an interlayer for a light emitting diode device.

### Description of Related Art

An ultraviolet (UV) light emitting diode (LED) emits UV light with a short wavelength, which is generally less than 400 nm. The ultraviolet portion of the electromagnetic spectrum is conventionally subdivided by wavelength into UVA (315-380 nm), UVB (280-315 nm) and UVC (<280 nm).

UV LED devices have been widely used in many applications, such as ultraviolet curing, for example curing a photoresist for the manufacture of semiconductors; phototherapy, for example to decrease bilirubin levels in infants with severe jaundice; water and air purification; bio-detection, for example portable warning systems for detecting the release of biological agents and germicidal treatment; UV LED color printing, and many other applications.

A conventional light emitting diode (LED) device includes a substrate, a buffer layer, a first conductivity type semiconductor layer, a light emitting layer, and a second conductivity type semiconductor layer. In an ultraviolet (UV) LED, an electron blocking layer (EBL) is typically included. The first conductivity type semiconductor layer provides holes and the second conductivity type semiconductor layer provides electrons, the holes and the electrons recombine at the light emitting layer to generate light. Because the electron mobility is greater than the holes mobility, electrons are more likely to escape from the light emitting layer, and this electron leakage will result in a decrease of light output. The EBL is conventionally used to suppress the electron leakage.

### SUMMARY

The present invention is a light emitting diode (LED) device including a substrate, a buffer layer, a first conductivity type semiconductor layer, a light emitting layer, an interlayer, an electron blocking layer, and a second conductivity type semiconductor layer. The thickness of the interlayer is substantially thinner than the thickness of the electron blocking layer.

In an embodiment of the present invention, the interlayer is doped with a p-type dopant, and the electron blocking layer is doped with a p-type dopant, and the concentration of the p-type dopant of the interlayer is lower than the concentration of the p-type dopant of the electron blocking layer.

It is to be understood that both the foregoing general description and the following detailed description are by examples, and are intended to provide further explanation of the invention as claimed.

### BRIEF DESCRIPTION OF THE DRAWINGS

The invention can be more fully understood by reading the following detailed description of the embodiment, with reference made to the accompanying drawings as follows:

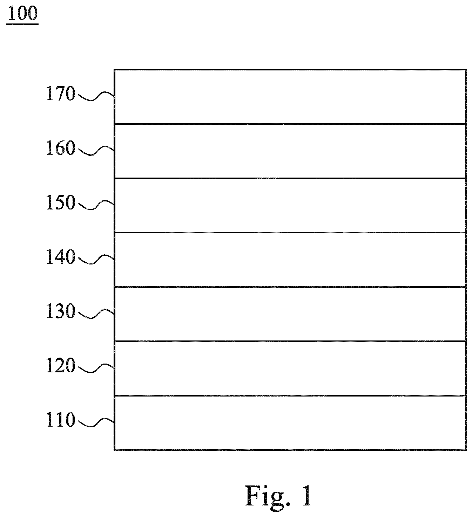

FIG. 1 is a schematic cross-sectional diagram of a light emitting diode device according to an embodiment of the present disclosure;
FIG. 2 is a light output power (a.u.) as a function of wavelength (nm) diagram of a light emitting diode device according to an embodiment of the present disclosure; and
FIG. 3 is a light output power (a.u.) as a function of wavelength (nm) diagram of a light emitting diode device according to another embodiment of the present disclosure.

### DETAILED DESCRIPTION

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically depicted in order to simplify the drawings.

An ultraviolet light emitting diode (UV-LED) is a high-energy device, so electron leakage is particularly severe, an electron blocking layer, typically composed of an aluminum nitride compound, is utilized to decrease electron leakage.

The present invention is a light emitting diode (LED) device 100 including a substrate 110, a buffer layer 120, a first conductivity type semiconductor layer 130, a light emitting layer 140, an interlayer 150, an electron blocking layer 160, and a second conductivity type semiconductor layer 170. The thickness of the interlayer 150 is substantially thinner than the thickness of the electron blocking layer 160.

In a preferred embodiment of the present invention, the interlayer 150 includes aluminum nitride and the electron blocking layer 160 includes aluminum gallium nitride.

In a preferred embodiment of the present invention, the thickness of the interlayer 150 is greater than or equal to 1 nm and less than 10 nm, and the thickness of the electron blocking layer 160 is greater than or equal to 10 nm and less than 50 nm.

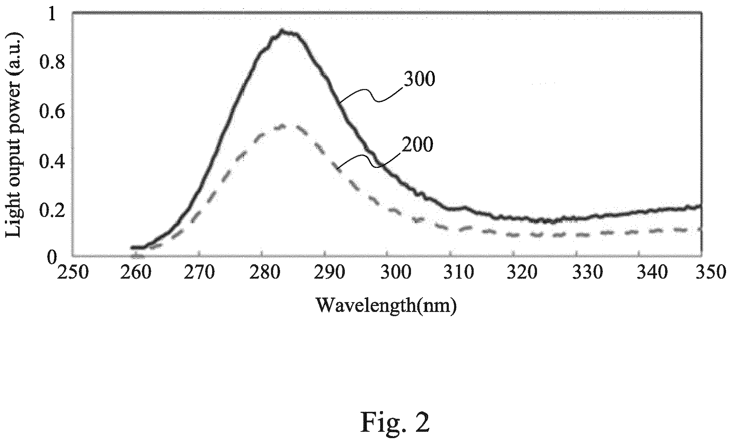

Figure 2 shows the light output power (a.u.) as a function of wavelength (nm) in which the lower curve 200 indicates light output power of an UV LED having only an EBL, and the upper curve 300 shows that light output power has increased over almost all the wavelength interval of the Figure 2 for an embodiment of the present invention utilizing an interlayer as an embodiment of the present invention.

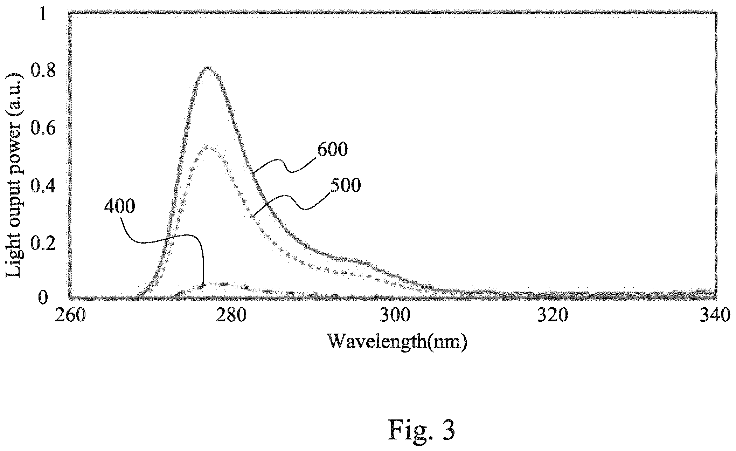

Figure 3 shows the light output power as a function of wavelength for an UV LED device having an EBL of 50 nm thickness, according to the present invention, the lowest curve 400 indicates the light output power of an UV LED having the EBL with an interlayer of a thickness thicker than that of EBL, the lower curve 500 indicates the light output power of an UV LED having the EBL with an interlayer of 10 nm thickness, and the upper curve 600 indicates the light output power of an UV LED having the EBL with an interlayer of 1.0 nm thickness. These experimental results show that the thinner interlayer is, the greater light output power over almost all the wavelength interval of the Figure 3 the UV LED has.

In an embodiment of the present invention, the interlayer 150 is doped with a p-type dopant, and the electron blocking layer 160 is doped with a p-type dopant, and the concentration of the p-type dopant of the interlayer 150 is lower than the concentration of the p-type dopant of the electron blocking layer 160.

In another embodiment of the present invention, the interlayer 150 includes aluminum nitride and the electron blocking layer 160 includes aluminum gallium nitride.

In yet another embodiment of the present invention, the concentration of the p-type dopant of the interlayer 150 is greater than or equal 1x10¹⁷ (atom/cm³) and less than 2x10¹⁸ (atom/cm³), and the concentration of the p-type dopant of the electron blocking layer 160 is greater than or equal 2x10¹⁸(atom/cm³) and less than or equal to 3x10¹⁹ (atom/cm³). If the concentration of the p-type dopant of the interlayer 150 is greater than 2x10¹⁸(atom/cm³), the interlayer may turn into n-type rather than p-type, so that the position of electron-hole combination will shift away from the light emitting layer and the wavelength of output light will deviate from predetermined range.

The present invention also includes a method for fabricating a light emitting diode including the steps of forming a substrate, forming a buffer layer on the substrate, forming a first conductivity type semiconductor layer on the buffer layer, forming a light emitting layer on the first conductivity type semiconductor layer, forming an interlayer on the light emitting layer, forming an electron blocking layer on the interlayer, and forming a second conductivity type semiconductor layer on the interlayer. The thickness of the interlayer is substantially thinner than the thickness of the electron blocking layer.

The present invention also discloses a method for fabricating a light emitting diode including the steps of forming a substrate, forming a buffer layer on the substrate, forming a first conductivity type semiconductor layer on the buffer layer, forming a light emitting layer on the first conductivity type semiconductor layer, forming an interlayer on the light emitting layer, doping the interlayer with a p-type dopant having a predetermined concentration, forming an electron blocking layer on the interlayer, doping the electron blocking layer with a p-type dopant having a predetermined concentration higher than the concentration of the dopant of the interlayer, and forming a second conductivity type semiconductor layer on the interlayer.

In one method of the present invention, the concentration of the p-type dopant of the interlayer is greater than or equal 1x10¹⁷ (atom/cm³) and less than 2x10¹⁸ (atom/cm³), and the concentration of the p-type dopant of the electron blocking layer is greater than or equal 2x10¹⁸ (atom/cm³) and less than or equal to 3x10¹⁹(atom/cm³).

## Claims

1. A light emitting diode (LED) device (100) **characterized in** comprising:
a substrate (110), a buffer layer (120), a first conductivity type semiconductor layer (130), a light emitting layer (140), an interlayer (150), an electron blocking layer (160), and a second conductivity type semiconductor layer (170) stacking in sequence, wherein the thickness of the interlayer (150) is substantially thinner than the thickness of the electron blocking layer (160).

2. The device of claim 1, **characterized in that** the interlayer (150) is comprised of aluminum nitride and the electron blocking layer (160) is comprised of aluminum gallium nitride.

3. The device of claim 1, **characterized in that** the thickness of the interlayer (150) is greater than or equal to 1 nm and less than 10 nm, and the thickness of the electron blocking layer (160) is greater than or equal to 10 nm and less than 50 nm.

4. A light emitting diode (LED) device (100) **characterized in** comprising:
a substrate (110), a buffer layer (120), a first conductivity type semiconductor layer (130), a light emitting layer (140), an interlayer (150), an electron blocking layer (160), and a second conductivity type semiconductor layer (170) stacking in sequence, wherein the interlayer (150) is doped with a p-type dopant, and the electron blocking layer (160) is doped with a p-type dopant, and wherein the concentration of the p-type dopant of the interlayer (150) is lower than the concentration of the p-type dopant of the electron blocking layer (160).

5. The device of claim 4, **characterized in that** the interlayer (150) is comprised of aluminum nitride and the electron blocking layer (160) is comprised of aluminum gallium nitride.

6. The device of claim 4, **characterized in that** the concentration of the p-type dopant of the interlayer (150) is greater than or equal 1x10¹⁷ (atom/cm³) and less than 2x10¹⁸ (atom/cm³), and the concentration of the p-type dopant of the electron blocking layer (160) is greater than or equal 2x10¹⁸ (atom/cm³) and less than or equal to 3x10¹⁹(atom/cm³).

7. A method for fabricating a light emitting diode **characterized in** comprising the steps of:
(a) forming a substrate (110);
(b) forming a buffer layer (120) on the substrate (110);
(c) forming a first conductivity type semiconductor layer (130) on the buffer layer (120);
(d) forming a light emitting layer (140) on the first conductivity type semiconductor layer (130);
(e) forming an interlayer (150) on the light emitting layer (140);
(f) forming an electron blocking layer (160) on the interlayer (150), ; and
(g) forming a second conductivity type semiconductor layer (170) on the interlayer (150), wherein the thickness of the interlayer is substantially thinner than the thickness of the electron blocking layer.

8. The method of claim 7, **characterized in that** the thickness of the interlayer (150) is greater than or equal to 1 nm and less than 10 nm, and the thickness of the electron blocking layer (160) is greater than or equal to 10 nm and less than 50 nm.

9. The method of claim 7, **characterized in that** the interlayer (150) is doped with p-type dopant having a predetermined concentration, and the electron blocking layer (160) is doped with a p-type dopant having a predetermined concentration higher than the concentration of the dopant of the interlayer (150).

10. The method of claim 7, **characterized in that** the concentration of the p-type dopant of the interlayer (150) is greater than or equal 1x10¹⁷ (atom/cm³) and less than 2x10¹⁸ (atom/cm³), and the concentration of the p-type dopant of the electron blocking layer (160) is greater than or equal 2x10¹⁸ (atom/cm³) and less than or equal to 3x10¹⁹ (atom/cm³).
